(19) **Europäisches Patentamt**
**European Patent Office**
**Office européen des brevets**

(11) Numéro de publication : **0 338 905 B1**

(12) **FASCICULE DE BREVET EUROPEEN**

(45) Date de publication du fascicule du brevet :
**16.12.92 Bulletin 92/51**

(51) Int. Cl.$^5$ : **H01J 37/20, H01L 21/00, C23C 8/36**

(21) Numéro de dépôt : **89401053.7**

(22) Date de dépôt : **17.04.89**

(54) **Dispositif de traitement par plasma de plaquettes conductrices.**

(30) Priorité : **19.04.88 FR 8805155**

(43) Date de publication de la demande :
**25.10.89 Bulletin 89/43**

(45) Mention de la délivrance du brevet :
**16.12.92 Bulletin 92/51**

(84) Etats contractants désignés :
**DE GB IT NL**

(56) Documents cités :
**EP-A- 0 036 061**
**EP-A- 0 142 450**
**US-A- 3 766 046**

(73) Titulaire : **FRANCE TELECOM**
**6, Place d'Alleray**
**F-75015 Paris (FR)**

(72) Inventeur : **Straboni, Alain**
**18, Rue Condorcet**
**F-38000 Grenoble (FR)**
Inventeur : **Vuillermoz, Bernard**
**22, Boulevard du Maréchal Leclerc**
**F-38000 Grenoble (FR)**
Inventeur : **Berenguer, Marc**
**101, Avenue Aristide Briand**
**F-38600 Fontaine (FR)**

(74) Mandataire : **Mongrédien, André et al**
**c/o BREVATOME 25, rue de Ponthieu**
**F-75008 Paris (FR)**

EP 0 338 905 B1

## Description

La présente invention se rapporte à un dispositif de traitement par plasma de plaquettes conductrices ou semi-conductrices, destiné notamment à l'oxydation ou la nitruration de plaquettes de silicium, au dépôt de couches isolantes ou semi-conductrices par la technique de dépôt chimique en phase vapeur assisté par plasma (PCVD) sur des plaquettes de silicium ou de matériaux III-V et à la gravure du type ionique réactive (GIR) de plaquettes semi-conductrices. Ces plaquettes conductrices ou semi-conductrices sont destinées à la fabrication de circuits intégrés.

Il est connu du document EP-A-0 039 406 un dispositif d'oxydation d'une plaquette conductrice, comportant un tube étanche de forme allongée, destiné à recevoir la plaquette à oxyder et parcouru par un courant d'oxygène, des moyens de création et d'excitation d'un plasma à l'une des extrémités du tube étanche. La plaquette à traiter est disposée perpendiculairement au courant de plasma et proche de la zone de création de celui-ci. Dans une variante, il est possible de traiter plusieurs plaquettes simultanément, mais ces dernières se trouvent dans un même plan transversal du tube.

Ce dispositif présente un certain nombre d'inconvénients. En particulier, il ne permet pas de maîtriser la croissance de l'oxyde et par conséquent, son épaisseur et sa régularité sur toute la surface de la plaquette. En outre, la plaquette à oxyder se trouve près de la zone d'excitation du plasma, ce qui entraîne une possibilité de dépôt, sur la plaquette, de particules oxydées provenant du tube lui-même dans la zone d'excitation du plasma et donc une pollution de la plaquette ou la création de défauts par interaction avec les espèces énergétiques issues du plasma.

En outre, dans la variante multi-plaquettes, ces dernières sont placées les unes à côté des autres dans un même plan transversal du tube entraînant ainsi un encombrement excessif du dispositif si l'on désire traiter un grand nombre de plaquettes simultanément.

Il a été proposé dans le document FR-A-2 555 360 un dispositif d'oxydation ou de nitruration de plaquettes de silicium permettant de remédier aux inconvénients ci-dessus. Il est apparu que ce dispositif nécessite l'utilisation d'un nouveau moyen de support des plaquettes permettant leur polarisation et qui soit simple et très efficace, bien qu'étant soumis à l'ambiance très agressive du plasma.

Par ailleurs, compte tenu de l'évolution actuelle de la micro-électronique et de la polarisation maintenant possible des plaquettes semi-conductrices, on cherche à mettre en oeuvre de plus en plus de réactions chimiques nouvelles en vue du dépôt ou de la gravure de nouveaux matériaux.

Aussi, l'invention a justement pour objet un perfectionnement du dispositif de traitement décrit dans ce document français afin de permettre le dépôt ou la gravure d'un grand nombre de matériaux sur des plaquettes semi-conductrices, pas forcément en silicium, et de bien maîtriser l'épaisseur du dépôt, de la croissance de la couche ou de gravure. En outre, dans le cas d'un dépôt ou d'une croissance, ceux-ci présentent une très grande homogénéité et une excellente qualité.

De façon plus précise, l'invention a pour objet un dispositif de traitement par plasma de plaquettes conductrices comportant :
- une enceinte étanche de traitement,
- un premier et un second bras porte-plaquettes, solidaires l'un de l'autre et destinés à être placés en porte-à-faux dans l'enceinte, ces bras comportant respectivement un premier et un second matériaux conducteurs de l'électricité gainés par respectivement un premier et un second matériaux isolants de l'électricité pourvus d'encoches, chaque encoche du premier matériau isolant étant associée à une encoche du second matériau isolant pour former une paire d'encoches destinée à supporter une seule plaquette transversalement au premier et second bras, l'une au moins des encoches de chaque paire d'encoches étant pratiquée sur toute l'épaisseur du matériau isolant correspondant afin d'assurer une mise en contact des plaquettes avec le matériau conducteur d'au moins un bras,
- une source d'alimentation électrique pour appliquer une tension de polarisation aux plaquettes, via les premier et second matériaux conducteurs ou via un des premier et second matériaux conducteurs et une électrode de référence, et,
- des moyens pour créer le plasma dans l'enceinte.

Par plaquettes "conductrices", il faut comprendre des plaquettes conductrices (en métal ou en oxyde conducteur) ou des plaquettes semi-conductrices.

Le dispositif selon l'invention peut être utilisé pour un grand nombre de dépôts, de croissance ou de gravures par plasma sur des plaquettes en silicium ou en matériau III-V (GaAs, InP, GaAlAs, etc.).

Dans le cas de plaquettes en silicium, on utilise avantageusement comme premier et second matériaux conducteurs du silicium polycristallin ou monocristallin et comme premier et second matériaux isolants de l'oxyde de silicium ($SiO_2$), du nitrure de silicium ($Si_3N_4$) ou de l'alumine ($Al_2O_3$) en vue de limiter au maximum la pollution des plaquettes principalement à haute température. En outre, le silicium présente des qualités remarquables de résistance mécanique, résistance mécanique nécessaire du fait du porte-à-faux des bras porte-plaquettes.

Toutefois, il est possible d'utiliser comme premier et second matériaux conducteurs de l'électricité de l'inox ou du carbone recouvert d'une couche épaisse de silicium polycristallin ou de tout autre matériau conducteur compatible avec le silicium (par exemple matériau utilisé pour le dopage n ou p du silicium).

De façon avantageuse, pour chaque paire d'encoches, une seule encoche est pratiquée sur toute l'épaisseur du matériau isolant correspondant ; par exemple une sur deux des encoches du premier matériau isolant est pratiquée sur toute l'épaisseur du premier matériau isolant et une sur deux des encoches du second matériau isolant est pratiquée sur toute l'épaisseur du second matériau isolant.

Cet agencement permet en particulier d'appliquer sur les premier et second matériaux conducteurs des potentiels différents $V_1$ et $V_2$ afin de créer des décharges capacitives entre deux plaquettes consécutives, créant ainsi le plasma ; le passage du courant, du premier matériau conducteur au second matériau conducteur ou inversement est assuré par les plaquettes en vis-à-vis et par le plasma situé dans cet espace.

Dans un autre mode de réalisation, toutes les encoches des premier et second matériaux isolants sont pratiquées sur toute l'épaisseur du matériau isolant correspondant, assurant ainsi une mise en contact de chaque plaquette avec respectivement les premier et second matériaux conducteurs. Dans ce cas, la différence de potentiel appliquée aux plaquettes est la même pour toutes assurant ainsi un dépôt, une croissance ou une gravure uniforme sur toutes les plaquettes.

D'autres caractéristiques et avantages de l'invention ressortiront mieux de la description qui va suivre, donnée à titre purement illustratif et non limitatif, en référence aux dessins annexés, dans lesquels :

- la figure 1 est une vue schématique, en coupe, d'un dispositif de traitement conforme à l'invention,
- la figure 2 est une vue schématique, de dessus, des bras porte-plaquettes du dispositif de la figure 1,
- la figure 3 est une vue en bout montrant le support d'une plaquette par les deux bras porte-plaquettes selon l'invention,
- la figure 4 est une vue schématique de côté, montrant le système d'accouplement des bras porte-plaquettes et des bras support mobiles de l'invention, et
- les figures 5 à 7 illustrent trois variantes de réalisation des encoches porte-plaquettes selon la tension appliquée à chacun des matériaux conducteurs des bras porte-plaquettes de l'invention.

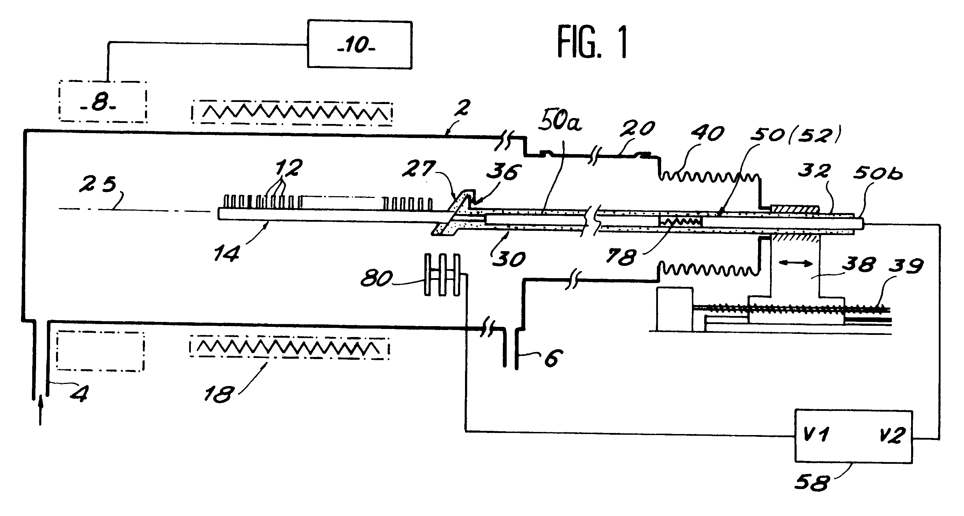

En référence à la figure 1, le dispositif selon l'invention comporte une enceinte de traitement étanche de forme tubulaire, réalisée en quartz et équipée d'une alimentation en gaz 4 et d'une sortie de gaz 6 destiné à constituer un plasma. Le gaz est en particulier de l'oxygène ou de l'ammoniac pour la croissance , des composés volatils du silicium pour le dépôt ou des gaz halogénés pour la gravure.

L'enceinte 2 est équipée, au voisinage de l'alimentation en gaz, de moyens de création d'un plasma qui peuvent consister en une électrode capacitive 8 reliée à un générateur haute fréquence 10.

Les plaquettes 12 à traiter sont placées sur un support-plaquettes, de référence générale 14, et situées dans une zone de l'enceinte 2 chauffée par des moyens extérieurs 18 du type résistance électrique. Un sas de chargement 20 des plaquettes est prévu en aval de la sortie 6 du courant gazeux.

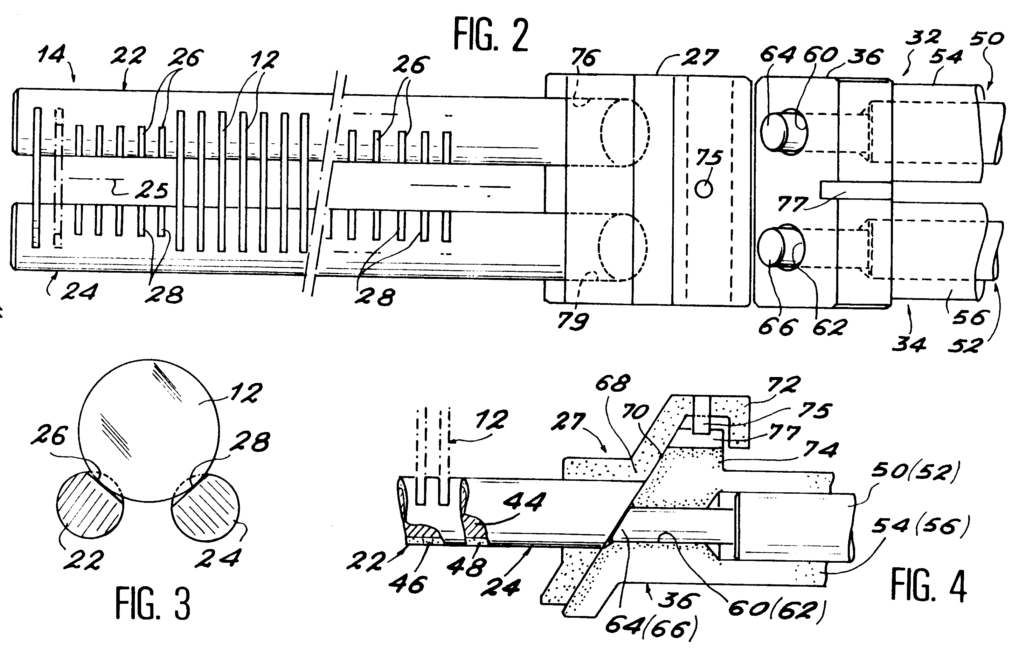

Conformément à l'invention, le support-plaquettes 14, du type en porte-à-faux ou du type "cantilever" en terminologie anglo-saxonne, est constitué, comme représenté sur la figure 2, de deux bras porte-plaquettes respectivement 22 et 24 de forme tubulaire disposés parallèlement et selon l'axe longitudinal 25 de l'enceinte 2. Les deux bras 22 et 24 sont rendus solidaires l'un de l'autre à l'aide d'une plaque d'extrémité 27, située du côté de la sortie de gaz 6.

Les plaquettes 12 à traiter sont disposées parallèlement entre elles et perpendiculairement à l'axe longitudinal 25 de l'enceinte 2, et donc aux bras porte-plaquettes 22, 24.

Une première série d'encoches 26 est prévue sur le bras 22 porte-plaquettes et une seconde série d'encoches 28 est prévue sur le bras 24 porte-plaquettes ; les encoches 26 et 28 sont en nombre égal. Le maintien de chaque plaquette à traiter 12 est alors assuré par une paire d'encoches formée d'une encoche 26 et d'une encoche 28 situées en regard l'une de l'autre, comme représenté sur la figure 3.

Conformément à l'invention, un système mobile 30 (figure 1) assure le déplacement du support-plaquettes 14, du sas 20 vers l'enceinte 2 en vue d'un traitement par plasma ou de l'enceinte 2 vers le sas 20, en vue du déchargement des plaquettes 12 traitées.

Ce système mobile 30 comporte deux bras support respectivement 32 et 34 (figure 2), de forme tubulaire, orientés parallèlement à l'axe longitudinal 25 de l'enceinte 2. Une plaque d'extrémité 36 permet de rendre solidaires les deux bras support 32 et 34, du côté de l'enceinte 2.

La plaque d'extrémité 36 est destinée à être plaquée sur la plaque d'extrémité 27, comme représenté sur les figures 2 et 3, afin de faire about er respectivement le bras porte-plaquettes 22 et le bras support 32 d'une part, et d'autre part, le bras porte-plaquettes 24 avec le bras support 34.

Afin d'assurer le déplacement du support-plaquettes 14, du sas de chargement 20 dans l'enceinte 2 et inversement (figure 1), les bras support 32 et 34 sont solidaires d'un chariot mobile 38, situé du côté opposé à la plaque d'extrémité 36 et dont le déplacement est par exemple assuré à l'aide d'un système 39 tige filetée-trou taraudé qui peut être activé manuellement ou automatiquement (à l'aide d'un moteur pas-à-pas).

Un soufflet 40 disposé en aval du sas d'introduction 20 et solidaire du chariot mobile 38, assure l'étanchéité de l'enceinte de traitement 2, lorsque cette dernière est placée sous vide, et empêche sa pollution par l'extérieur tout en permettant le déplacement du support-plaquettes 14 dans l'enceinte 2.

Comme représenté sur les figures 4 à 7, les bras porte-plaquettes 22 et 24 sont constitués d'une âme centrale respectivement 42 et 44 réalisées en un matériau conducteur de l'électricité et en particulier en un barreau de silicium monocristallin ; ces barreaux conducteurs sont gainés respectivement d'un matériau isolant 46 et 48 en particulier en $SiO_2$ ou en $Si_3N_4$.

De même, les bras-support 32 et 34 sont constitués, comme représenté sur les figures 2 et 4, d'une âme centrale respectivement 50 et 52 réalisées en un matériau conducteur et en particulier en un barreau de silicium monocristallin. Le barreau conducteur 50 est pourvu d'une gaine 54 en matériau isolant et le barreau 52 est pourvu d'une gaine 56 isolante ; les gaines 54 et 56 sont en particulier réalisées en oxyde de silicium ou en nitrure de silicium.

Selon l'invention, une source d'alimentation électrique 58, continue ou alternative et située en dehors de l'enceinte 2 (figures 1, 5-7), est connectée aux barreaux conducteurs 50 et 52, eux-mêmes connectés aux barreaux conducteurs 42 et 44 en vue de polariser les plaquettes 12 à traiter.

Afin d'assurer le contact électrique entre les barreaux conducteurs 50, 52 et respectivement 42 et 44, la plaque d'extrémité 36 de support des bras-support 32 et 34 est pourvue, comme représenté sur les figures 2 et 4, de deux alésages 60 et 62 destinés à recevoir respectivement deux doigts conducteurs 64 et 66 en matériaux conducteurs, et en particulier en silicium monocristallin, prolongeant respectivement les barreaux conducteurs 50 et 52. Ces doigts conducteurs 64 et 66 sont destinés respectivement à venir abouter l'âme conductrice 42 et 44 des bras porte-plaquettes 22 et 24.

Selon l'invention, la plaque d'extrémité 36 est réalisée en un matériau isolant de l'électricité et notamment en $SiO_2$ ou $Si_3N_4$. Pratiquement, la plaque d'extrémité 36 et les gaines isolantes 54 et 56 sont fabriquées dans le même bloc isolant.

Par ailleurs, la plaque d'extrémité 27 supportant les bras porte-plaquettes 22 et 24 comportent une partie centrale 68 destinée à être plaquée sur la face 70 de la plaque d'extrémité 36 et un bord replié comportant une partie 72 destinée à venir s'appuyer sur la face 74 de la plaque 36, opposée à la face 70. Le bord replié constitue un crochet (ou un U à l'envers) venant s'accrocher sur la partie supérieure de la plaque d'extrémité 36. Un doigt de centrage 75 et une fente 77 correspondante assurent l'immobilisation latérale.

Selon l'invention, la plaque d'extrémité 27 est constituée en un matériau isolant par exemple en $SiO_2$ ou $Si_3N_4$. Pratiquement, la plaque d'extrémité 27 et les deux gaines isolantes 42 et 44 sont réalisées dans le même bloc isolant.

Afin d'assurer le passage du courant électrique entre les barreaux conducteurs 42 et 50 d'une part, et 44 et 52 d'autre part, la plaque d'extrémité 27 (figures 2, 4) est pourvue de deux alésages 76 et 79 destinés à recevoir respectivement l'extrémité des barreaux conducteurs 42 et 44 devant être appliquée respectivement sur les doigts conducteurs 64 et 66.

Par ailleurs, comme représenté sur la figure 1, le barreau conducteur 50 du bras-support 42 est constitué de deux parties 50a et 50b conductrices couplées par une zone élastique 78 conductrice telle qu'un ressort de rappel soudé sur les deux parties 50a et 50b du barreau conducteur 50. Ce ressort est réalisé en un matériau conducteur de l'électricité et en particulier en acier. De même, le barreau conducteur 52 est formé de deux parties couplées par un ressort soudé sur lesdites parties.

En position comprimée, les ressorts 78 assurent le contact électrique des doigts conducteurs 64 et 66 avec respectivement les barreaux 42 et 44 conducteurs des bras porte-plaquettes.

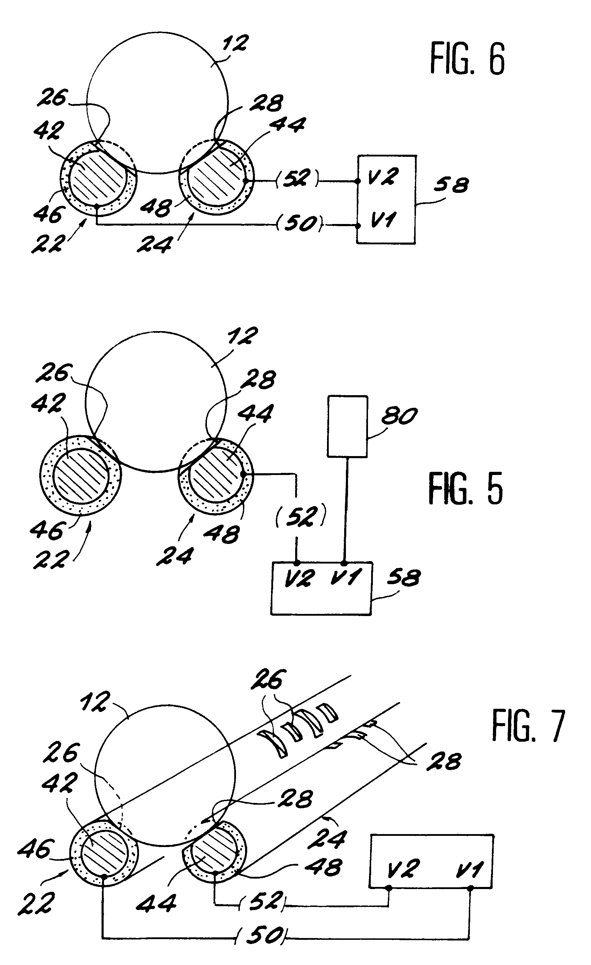

Dans une première variante représentée sur les figures 1 et 5, une électrode de référence 80 est placée à l'intérieur de l'enceinte de traitement 2 en regard du système porte-plaquettes 14. Cette électrode est reliée à la source d'alimentation électrique continue 58 et doit présenter une surface de contact avec le plasma compatible avec l'intensité de courant traversant les plaquettes, courant augmentant avec le nombre de plaquettes à traiter. Ceci explique la forme particulière de l'électrode de référence.

Dans ce premier mode de réalisation, un seul barreau conducteur par exemple 44 des bras porte-plaquettes est relié à la source d'alimentation électrique 58, via le barreau conducteur du bras-support correspondant, par exemple 52.

Le potentiel $V_2$ appliqué au barreau conducteur 44 peut être positif ou négatif par rapport à la tension de référence $V_1$ appliquée à l'électrode de référence 80 ou appliquée directement au sas 20 si celui-ci est métallique, suivant la nature du dépôt ou de la gravure à effectuer sur les plaquettes 12. Le potentiel de référence $V_1$ est par exemple le potentiel de la masse.

Par exemplee, si l'on désire une oxydation des plaquettes de silicium 12, l'enceinte 2 est parcourue par un courant d'oxygène et le barreau conducteur 44 est porté à un potentiel $V_2$ positif par rapport à l'électrode de référence. De même, si l'on désire réaliser une nitruration des plaquettes de silicium 12, l'enceinte 2 est parcourue par un courant d'azote et le barreau conducteur 44 est porté à un potentiel électrique $V_2$ négatif par rapport à celui de l'électrode de référence.

Dans ce premier mode de réalisation, les encoches 28 du bras porte-plaquettes 24 sont pratiquées sur toute l'épaisseur du matériau isolant 48, comme représenté sur la figure 6, afin d'assurer un contact physique et donc un contact électrique entre le barreau conducteur 44 et la plaque 12 placée dans l'encoche 28. En outre, afin d'éviter un court-circuit au niveau de la plaquette 12, l'encoche correspondante 26 du bras porte-plaquettes 22 est pratiquée sur une faible épaisseur de l'isolant 46. Aussi, une zone 82 d'isolant est prévue entre le barreau conducteur 42 et la plaquette 12, évitant ainsi la mise en contact électrique du barreau conducteur 42 avec la plaquette 12.

Pour assurer un dépôt ou une gravure d'un matériau, simultanément sur toutes les plaquettes disposées dans l'enceinte de traitement 2, toutes les encoches 28 du bras 24 sont pratiquées sur toute l'épaisseur de l'isolant 48 alors que toutes les encoches 26 du bras 22 sont pratiquées sur une partie seulement de l'épaisseur de l'isolant 46.

Afin de permettre une meilleure polarisation des plaquettes 12 à traiter, et donc un meilleur contrôle de l'épaisseur de dépôt ou de gravure, il est possible, comme représenté sur la figure 6, de brancher la source d'alimentation électrique 58 continue ou alternative aux deux barreaux conducteurs 42 et 44 via respectivement les barreaux conducteurs 50 et 52.

Dans ce second mode de réalisation, toutes les encoches par exemple 28 du bras porte-plaquettes 24 sont pratiquées sur toute l'épaisseur de l'isolant 48 afin de mettre en contact physique, donc électrique, le barreau conducteur 44 et la plaquette 12. De même, toutes les encoches 26 du bras porte-plaquettes 22 sont pratiquées sur toute l'épaisseur de l'isolant 46 afin de mettre en contact physique le barreau conducteur 42 et la plaquette 12 correspondante. Dans ce cas, le passage du courant entre le barreau conducteur 42 et le barreau conducteur 44 est assuré par les plaquettes 12.

Si $V_1$ constitue le potentiel de référence, par exemple le potentiel de la masse, $V_2$ peut être un potentiel négatif ou positif suivant le type de réaction chimique envisagée.

Comme dans le mode de réalisation de la figure 5, le mode de réalisation représenté sur la figure 6 ne permet le dépôt ou la gravure d'un matériau que de façon homogène et simultanée sur toutes les plaquettes 12 placées à l'intérieur de l'enceinte.

Dans un autre mode de réalisation représenté sur la figure 7, une encoche sur deux 28 du bras 24 porte-plaquettes est pratiquée sur toute l'épaisseur de l'isolant 48 afin d'assurer un contact physique donc électrique entre le barreau 44 et l'électrode 12 située dans l'encoche 28. De même, une sur deux des encoches 26 du bras porte-plaquettes 22 est pratiquée sur toute l'épaisseur de l'isolant 46 afin d'assurer un contact physique entre le barreau conducteur 42 et la plaquette 12 située dans l'encoche 26.

Dans ce troisième mode de réalisation, lorsqu'une encoche 28 est pratiquée sur toute l'épaisseur de l'isolant 48, l'encoche 26 qui lui est appairée pour supporter la même plaquette 12 n'est pratiquée que sur une partie seulement de l'isolant 46 afin de laisser une zone isolante 88 entre la plaquette 12 et le barreau conducteur 42. Inversement, lorsqu'une encoche 26 est pratiquée sur toute l'épaisseur de l'isolant 46, l'encoche 28 qui lui est appairée n'est pratiquée que sur une partie de l'isolant 48 afin qu'une zone isolante subsiste entre le barreau conducteur 44 et la plaquette 12 disposée dans cette encoche 28.

Dans ce troisième mode de réalisation, les barreaux conducteurs 42 et 44 sont connectés, via respectivement les barreaux conducteurs 50 et 52, aux deux bornes de la source d'alimentation électrique 58. L'application d'un potentiel $V_1$ positif continu et l'application d'un potentiel $V_2$ positif supérieur à $V_1$ permettent la polarisation d'une plaquette sur deux à une tension plus élevée. Le courant est alors transmis du barreau conducteur 42 au barreau conducteur 44 à l'aide de deux plaquettes 12 consécutives.

Il est ainsi possible de déposer ou de graver le même matériau avec des épaisseurs différentes d'une plaquette à l'autre. En outre, le courant traversant chaque plaquette d'un même traitement peut être mieux contrôlé assurant ainsi une épaisseur uniforme du dépôt ou de la gravure d'une même plaquette.

Afin de connaître à coup sûr, l'épaisseur de dépôt ou de gravure, la source 58 peut être équipée d'un système de mesure de la quantité de courant fourni aux plaquettes.

A titre d'exemple, il est possible de faire croître une couche de $SiO_2$ de 600 nm sur 200 plaquettes de silicium avec un débit d'oxygène de 50 $cm^3$/min, une pression de 3 Pa dans l'enceinte 2, une tension $V_2$ positive de 200 volts par rapport à la masse pendant 60 min, pour les modes de réalisation des figures 5 et 6.

Il est possible aussi d'effectuer successivement, dans un même bâti et avec les mêmes gaz, une gravure puis un dépôt ou une croissance. Par exemple, on peut obtenir une première opération de nettoyage plasma, en polarisant négativement les plaquettes, puis obtenir un dépôt ou une croissance en laissant le potentiel flottant (électrode de référence) ou en polarisant positivement les plaquettes.

## Revendications

1. Dispositif de traitement par plasma de plaquettes conductrices comportant :
   - une enceinte (2) étanche de traitement,
   - un premier (22) et un second (24) bras porte-plaquettes, solidaires l'un de l'autre et destinés à être placés en porte-à-faux dans l'enceinte (2), ces bras (22, 24) comportant respectivement un premier (42) et un second (44) matériaux conducteurs de l'électricité gainés par respectivement un premier (46) et un second (48) matériaux isolants de l'électricité pourvus d'encoches (26, 28), chaque encoche (26) du premier matériau isolant étant associée à une encoche (28) du second matériau isolant pour former une paire d'encoches (26, 28) destinée à supporter une seule plaquette (12) transversalement aux premier et second bras, l'une au moins des encoches (28) de chaque paire d'encoches étant pratiquée sur toute l'épaisseur du matériau isolant correspondant afin d'assurer une mise en contact des plaquettes avec le matériau conducteur (48) d'au moins un bras,
- une source d'alimentation électrique (58) pour appliquer une tension de polarisation aux plaquettes (12), via les premier et second matériaux conducteurs (42, 44) ou via un des premier et second matériaux conducteurs (42,44) et une électrode de référence (80), et,
- des moyens (8, 10) pour créer le plasma dans l'enceinte (2).

2. Dispositif selon la revendication 1, caractérisé en ce qu'il comprend en outre des troisième (32) et quatrième (34) bras aptes à se déplacer longitudinalement, formés respectivement d'un troisième (50) et quatrième (52) matériaux conducteurs de l'électricité gainés par respectivement un troisième (54) et un quatrième (56) matériaux isolants de l'électricité et des moyens (27, 36) d'accouplement des différents bras afin de faire abouter les premier et troisième matériaux conducteurs (42, 50) d'une part et les second et quatrième matériaux conducteurs (44, 52) d'autre part, les troisième et quatrième bras (32, 34) étant intercalés entre la source d'alimentation (58) et respectivement les premier et second bras (22, 24).

3. Dispositif selon la revendication 1 ou 2, caractérisé en ce que toutes les encoches (26, 28) des premier et second matériaux isolants (46, 48) sont pratiquées sur toute l'épaisseur du matériau isolant correspondant, assurant ainsi une mise en contact de chaque plaquette (12) avec respectivement les premier et second matériaux conducteurs (42, 44).

4. Dispositif selon la revendication 1 ou 2, caractérisé en ce qu'une seule encoche (26, 28) de chaque paire d'encoches est pratiquée sur toute l'épaisseur du matériau isolant (46, 48) correspondant, une sur deux des encoches (26) du premier matériau isolant (46) étant pratiquée sur toute l'épaisseur du premier matériau isolant et une sur deux des encoches (28) du second matériau isolant (48) étant pratiquée sur toute l'épaisseur du second matériau isolant.

5. Dispositif selon l'une quelconque des revendications 1 à 4, pour traitement par plasma de plaquettes (12) de silicium.

6. Dispositif selon la revendication 5, caractérisé en ce que les premier et second matériaux conducteurs (42, 44) sont en silicium.

7. Dispositif selon la revendication 5 ou 6, caractérisé en ce que les premier et second matériaux isolants (46, 48) sont en dioxyde ou nitrure de silicium ou en alumine ($Al_2O_3$).

8. Dispositif selon l'une quelconque des revendications 1 à 7, caractérisé en ce que le premier matériau conducteur (42) est porté à un potentiel $V_1$ et le second materiau conducteur (44) à un potentiel $V_2$ différent de $V_1$.

9. Dispositif selon la revendication 8, caractérisé en ce que la source d'alimentation électrique (58) est une source d'alimentation alternative.

10. Dispositif selon l'une quelconque des revendications 1 à 9, caractérisé en ce que les moyens d'accouplement comportent une première plaque d'extrémité (36) en un cinquième matériau isolant de l'électricité, solidaire des troisième et quatrième bras (32, 34), une seconde plaque d'extrémité (27) en un sixième matériau isolant de l'électricité, solidaire des premier et second bras (22, 24) et pourvue d'une partie centrale (68) destinée à être plaquée sur une face (70) de la première plaque (36) et pourvue d'une partie repliée (72) destinée à venir s'appuyer sur l'autre face (74) de la première plaque (36), la première plaque (36) et ladite partie centrale (68) comportant chacune des alésages (60, 62 ; 76, 79) pour assurer respectivement le passage d'un premier et d'un second doigts conducteurs (64, 66) prolongeant respectivement les troisième et quatrième matériaux conducteurs (50, 52), lesdits doigts destinés à être plaqués sur une extrémité respectivement du premier et du second matériaux conducteurs.

11. Dispositif selon la revendication 10, caractérisé en ce que les troisième et quatrième matériaux conducteurs (50, 52) comportent une partie élastique (78) conductrice de l'électricité, assurant le placage des premier et second doigts (64, 66) sur une extrémité respectivement du premier et du second matériaux conducteurs (42, 44).

**Patentansprüche**

1. Vorrichtung zur Behandlung von Leiterplatten durch Plasma, enthaltend
   - ein abgedichtetes Behandlungsgefäß (2),
   - einen ersten (22) und einen zweiten (24) Plattentragarm, die miteinander fest verbunden sind und dazu bestimmt sind, freitragend im Gefäß (2) angeordnet zu werden, wobei diese Arme (22, 24) ein erstes (42) bzw. ein zweites (44) elektrisch leitendes Material, ummantelt mit einem ersten (46) und einem zweiten (48), mit Kerben (26, 28) versehenen, isolierenden Material, tragen, wobei jede Kerbe (26) des ersten isolierenden Materials mit einer Kerbe (28) des zweiten isolierenden Materials ein Kerbenpaar (26, 28) bildet, das dazu bestimmt ist, eine einzelne Platte (12) quer zum ersten und zweiten Arm zu tragen, wobei mindestens eine der Kerben (28) jeden Kerbenpaares durch die ganze Dicke des entsprechenden isolierenden Materials ausgeführt ist, um den Kontakt der Platten mit dem leitenden Material (48) mindestens eines Armes sicherzustellen,
   - eine elektrische Versorgungsquelle (58) zum Anlegen einer Vorspannung an die Platten (12) über die ersten und zweiten leitendon Materialien (42, 44) oder über das erste oder das zweite leitende Material (42, 44) und eine Bezugselektrode (80) und
   - Mittel (8, 10) zur Erzeugung des Plasmas im Gefäß (2).

2. Vorrichtung gemäß Patentanspruch 1, dadurch gekennzeichnet, daß die darüber hinaus einen dritten (32) und vierten (34) Arm aufweist, die in der Lage sind, sich in Längsrichtung zu bewegen und aus einem dritten (50) bzw. vierten (52) elektrisch leitenden Material, ummantelt mit einem dritten (54) und einem vierten (56) isolierenden Material, bestehen, und Mittel (27, 36) zur Koppelung der verschiedenen Arme, um die ersten und dritten leitenden Materialien (42, 50) einerseits und die zweiten und vierten leitenden Materialien (44, 52) andererseits aneinanderstoßen zu lassen, wobei der dritte und vierte Arm (32. 34) zwischen der Versorgungsquelle (58) und dem ersten bzw. zweiten Arm (22, 24) eingefügt sind.

3. Vorrichtung gemäß Patentanspruch 1 oder 2, dadurch gekennzeichnet, daß alle Kerben (26, 28) im ersten und zweiten isolierenden Material (46, 48) durch die ganze Dicke des entsprechenden isolierenden Materials ausgeführt sind und so den Kontakt jeder Platte (12) mit dem ersten bzw. zweiten leitenden Material (42, 44) sicherstellen.

4. Vorrichtung gemäß Patentanspruch 1 oder 2, dadurch gekennzeichnet, daß eine einzige Kerbe (26, 28) jedes Kerbenpaares durch die ganze Dicke des entsprechenden isolierenden Materials (46, 48) ausgeführt ist, wobei jede zweite der Kerben (26) des ersten isolierenden Materials (46) durch die ganze Dicke des ersten isolierenden Materials ausgeführt ist und jede zweite der Kerben (28) des zweiten isolierenden Materials (48) durch die ganze Dicke der zweiten isolierenden Materials.

5. Vorrichtung gemäß irgendeinem der Patentansprüche 1 bis 4 zur Behandlung von Siliziumplatten (12) durch Plasma.

6. Vorrichtung gemäß Patentanspruch 5, dadurch gekennzeichnet, daß die ersten und zweiten leitenden Materialien (42, 44) aus Silizium bestehen.

7. Vorrichtung gemäß Patentanspruch 5 oder 6, dadurch gekennzeichnet, daß die ersten und zweiten isolierenden Materialien (46, 48) aus Siliziumdioxid oder -nitrid oder aus Aluminiumoxid ($Al_2O_3$) bestehen.

8. Vorrichtung gemäß irgendeinem der Patentansprüche 1 bis 7, dadurch gekennzeichnet, daß an das erste leitende Material (42) ein Potential $V_1$ und an das zweite leitende Material (44) ein von $V_1$ verschiedenes Potential $V_2$ angelegt wird.

9. Vorrichtung gemäß Patentanspruch 8, dadurch gekennzeichnet, daß die elektrische Versorgungsquelle (58) eine Wechselstromversorgungsquelle ist.

10. Vorrichtung gemäß irgendeinem der Patentansprüche 1 bis 9, dadurch gekennzeichnet, daß die Kopplungsmittel eine erste Endplatte (36) aus einem fünften isolierenden Material aufweisen, die mit dem dritten und vierten Arm (32, 34) fest verbunden ist, eine zweite Endplatte (27) aus einem sechsten isolierenden Material, die mit dem ersten und zweiten Arm (22, 24) fest verbunden ist und einen zentralen Bereich (68) aufweist, der dazu bestimmt ist, an eine Fläche (70) der ersten Platte (36) angelegt zu werden, und mit einem zurückgebogenen Bereich (72), der dazu bestimmt ist, sich an die andere Fläche (74) der ersten Platte (36) anzulegen, wobei die erste Platte (36) und der genannte zentrale Bereich (68) Bohrungen (60, 62; 76, 79) aufweisen, um den Durchgang eines ersten bzw. eines zweiten Führungszapfens (64, 66) zu ermöglichen, die jeweils die dritten und vierten leitenden Materialien (50, 52) fortsetzen, wobei die genannten Zapfen dazu bestimmt sind, an ein Ende des ersten bzw. des zweiten leitenden Materials angelegt zu werden.

11. Vorrichtung gemäß Patentanspruch 10, dadurch gekennzeichnet, daß die dritten und vierten leitenden Materialien (50, 52) einen elektrisch leitenden, elastischen Bereich (78) aufweisen, der das Anlegen des ersten und zweiten Zapfens (64, 66) an ein Ende des ersten bzw. des zweiten leitenden Materials (42, 44) sicherstellt.

**Claims**

1. Means for the plasma processing of conducting wafers comprising:
   - a sealed processing enclosure (2),
   - a first (22) and a second (24) wafer bearing arm, which are integral with each other and designed to be cantilevered into enclosure (2), these arms (22, 24) comprising respectively a first (42) and a second (44) electrically conducting material sheathed respectively by a first (46) and a second (48) electrically insulating material provided with notches (26, (28), each notch (26) in the first insulating material being associated with a notch (28) in the second insulating material to form a pair of notches (26, 28) designed to support a single wafer (12) transversely to the first and second arms, at least one of the notches (28) in each pair of notches being made through the full thickness of the corresponding insulating material in order to ensure contact between the wafers and the conducting material (48) of at least one arm,
   - a source of electricity supply (58) to apply a polarising voltage to the wafers (12) via the first and second conducting materials (42, 44) or via one of the first and second conducting materials (42, 44) and a reference electrode (80), and,
   - means (8, 10) for creating a plasma within the enclosure (2).

2. Means according to claim 1, characterised in that it also comprises third (32) and fourth (34) arms which are capable of moving longitudinally, formed respectively of third (50) and fourth (52) electrically conducting materials sheathed respectively by a third (54) and a fourth (56) electrically insulating material and means (27, 36) for coupling the different arms so that the first and third conducting materials (2, 5) of the one part and the second and fourth conducting materials (44, 52) of the second part abut, the third and fourth arms (32, 34) being inset between the source of supply (58) and the first and second arms (22, 24) respectively.

3. Means according to claim 1 or 2, characterised in that all the notches (26, 28) in the first and second insulating materials (46, 48) are made through the full thickness of the corresponding insulating material thus ensuring contact between each wafer (12) and the first and second conducting materials (42, 44) respectively.

4. Means according to claim 1 or 2, characterised in that a single notch (26, 28) in each pair of notches is made through the full thickness of the corresponding insulating material (46, 48), one of the two notches (26) in the first insulating material (46) being made through the full thickness of the first insulating material and one of the two notches (28) in the second insulating material (48) being made through the full thickness of the second insulating material.

5. Means according to any one of claims 1 to 4 for the plasma treatment of silicon wafers (12).

6. Means according to claim 5, characterised in that the first and the second conducting materials (42, 44) are of silicon.

7. Means according to claim 5 or 6, characterised in that the first and second insulating materials (46, 48) are of silicon dioxide or nitride or alumina $(Al_2O_3)$.

8. Means according to any one of claims 1 to 7, characterised in that the first conducting material (42) is brought to a potential $V_1$ and the second conducting material (44) is brought to a potential $V_2$ which is different from $V_1$.

9. Means according to claim 8, characterised in that the source of electrical supply (8) is an alternating source of supply.

10. Means according to any one of claims 1 to 9, characterised in that the coupling means comprise a first end plate (36) of a fifth electrically insulating material which is integral with the third and fourth arms (32, 34), a second end plate (27) of a sixth electrically insulating material, integral with the first and second arms (22, 24), and having a central portion (68) which is designed to be pressed against one side (70) of the first plate (36) and a folded portion (72) which is intended to bear against the other side (74) of the first plate (36), the first plate (36) and the said central portion (68) each having bores (60, 62; 76, 79) to ensure the passage respectively of a first and second conducting finger (64, 66) extending the third and fourth conducting materials (50, 52) respectively, the said fingers being designed to press against one end respectively of the first and the second conducting materials.

11. Means according to claim 10, characterised in that the third and fourth conducting materials (50, 52) comprise an electrically conducting elastic portion (78) which ensures that the first and second fingers (64, 66) are pressed against one end of the first and second conducting materials (42, 44) respectively.

FIG. 1

FIG. 2

FIG. 3

FIG. 4

EP 0 338 905 B1

FIG. 6

FIG. 5

FIG. 7